# EUROPEAN PATENT APPLICATION

(11) **EP 4 601 199 A1**
(43) Date of publication of application: **13.08.2025**
(21) Application number: 23909053.3
(22) Date of filing: 27.06.2023
(51) Int. Cl.: H03M 1/00

(54) **ANALOG-TO-DIGITAL CONVERSION DEVICE AND METHOD**

(30) Priority: 31.12.2022 CN 202211735587
(71) Applicant: Sanechips Technology Co., Ltd., Shenzhen, Guangdong 518055 (CN)
(72) Inventor: GUO, Anqiang, Shenzhen, Guangdong 518055 (CN); CAI, Renhuan, Shenzhen, Guangdong 518055 (CN)
(74) Representative: Chimini, Francesco
(86) International application number: PCT/CN2023/102897
(87) International publication number: WO 2024/139108

(57) **Abstract**

The invention provides an analog-to-digital conversion device and method. The analog-to-digital conversion device includes: an analog-to-digital converter, wherein the analog-to-digital converter includes N successive approximation register (SAR) analog-to-digital converters and M slope analog-to-digital converters, N is a positive integer greater than or equal to 1, and M is a positive integer greater than 1; output ends of the N SAR analog-to-digital converters are connected to input ends of the M slope analog-to-digital converters.

## Description

### Cross-Reference to Related Application

This invention is based on Chinese patent application CN 202211735587.1 filed on December 31, 2022 and entitled "ANALOG-TO-MODULATE CONVERSION DEVICE AND METHOD", and claims the priority to the invention, which is incorporated in its entirety herein by reference.

### Technical Field

Embodiments of the present invention relate to the field of communications, and in particular, to an analog-to-digital conversion device and method.

### Background

A successive approximation register (SAR) analog-to-digital converter (ADC), a slope analog-to-digital converter, and a pipeline analog-to-digital converter are all prior art, the present invention belongs to the technical architecture disclosed in the documents in the professional field, in which a conversion rate of an SAR ADC is inversely related to the number of quantization bits, i.e. in the same case, the higher the quantization precision, the slower the conversion rate, and the inherent degree of matching in the process of manufacturing a unit capacitor device is difficult to meet the requirements of high precision; the conversion rate of the Slope ADC is also inversely related to the number of quantization bits, and in the same case, the quantization precision is increased, the conversion time is longer, taking a binary as an example, the number of quantization bits is increased by 1 bit every time, and the conversion time is 1 multiple; the Pipe line ADC parallels several stages of sub-ADCs stage by stage in a pipeline form, so that the circuit complexity is high, the ratio of power consumption for gain amplification between stages is large, and the multi-stage gain calibration between stages is complex.

The conventional practice of the presently disclosed technology is to optimize and calibrate the energy efficiency of the SAR ADC, and to interleave the Slope ADC, a targeted pipeline ADC speed optimization technology, wherein a SAR ADC and a Slope ADC are in a compromise between speed and precision, it is difficult to achieve high-speed and high-precision analog-to-digital conversion. Although a pipeline ADC has a speed advantage, conversion precision and a pipeline number are required to be compromised, high precision often implies high complexity and large power consumption.

### Summary

Embodiments of the present invention provide an analog-to-digital conversion device and method, so as to at least solve the problem in the related art that high-speed and high-precision analog-to-digital conversion cannot be achieved and the power consumption of the analog-to-digital conversion is too large.

An embodiment of the present invention provides an analog-to-digital conversion device, including: an analog-to-digital converter, wherein the analog-to-digital converter includes N successive approximation register (SAR) analog-to-digital converters and M slope analog-to-digital converters, N being a positive integer greater than or equal to 1, and M being a positive integer greater than 1; and output ends of the N SAR analog-to-digital converters are connected to input ends of the M slope analog-to-digital converters.

Another embodiment of the present invention provides an analog-to-digital conversion method, implemented by using the analog-to-digital conversion apparatus, including: the SAR analog-to-digital converter acquires an analogue voltage signal, and performs successive approximation analogue-to-digital conversion on the analogue voltage signal according to timing information; according to the successive approximation analog-to-digital conversion signal and the analog voltage signal, obtaining a quantization residue of the SAR analog-to-digital converter, and obtaining a first quantized output signal; the quantization residue enters the slope analog-to-digital converter via the inter-stage gain module, and the slope analog-to-digital converter performs comparison processing on the quantization residue according to the timing information, so as to obtain a second quantized output signal; the alignment encoding module aligns the first quantized output signal and the second quantized output signal according to the timing information, and encoding output the first quantized output signal and the second quantized output signal according to an inter-stage gain relation.

### Brief Description of the Drawings

Fig. 1 is a structural block diagram of an analog-to-digital conversion device according to an embodiment of the present invention;
Fig. 2 is a structural block diagram of an analog-to-digital conversion device according to an embodiment of the present invention
Fig. 3 is a structural block diagram of an analog-to-digital conversion device according to an embodiment of the present invention;
Fig. 4 is a structural block diagram of an analog-to-digital conversion device according to an embodiment of the present invention;
Fig. 5 is a structural block diagram of an analog-to-digital conversion device according to an embodiment of the present invention;
Fig. 6 is a flowchart of an analog to digital conversion method according to an embodiment of the present invention;
Fig. 7 is a schematic structural diagram of an analog-to-digital conversion device according to an embodiment of a scenario of the present invention;
Fig. 8 is an example schematic diagram of the timing of an analog-to-digital conversion device according to a scenario embodiment of the present invention;
Fig. 9 is a structural principle diagram of an analog-to-digital conversion device according to an embodiment of a scenario of the present invention;
Fig. 10 is a schematic diagram of an example of the timing of an analog-to-digital conversion device according to a scenario embodiment of the present invention;
Fig. 11 is a schematic structural diagram of an analog-to-digital conversion device according to an embodiment of a scenario of the present invention;
Fig. 12 is an exemplary schematic diagram of the timing of an analog-to-digital conversion device according to a scenario embodiment of the present invention.

### Detailed Description of the Embodiments

Embodiments of the present invention will be described below in detail with reference to the accompanying drawings and in conjunction with embodiments.

It should be noted that terms such as "first" and "second" in the description and claims of the embodiments of the present invention and the drawings are used to distinguish similar objects, and are not necessarily used to describe a specific sequence or order.

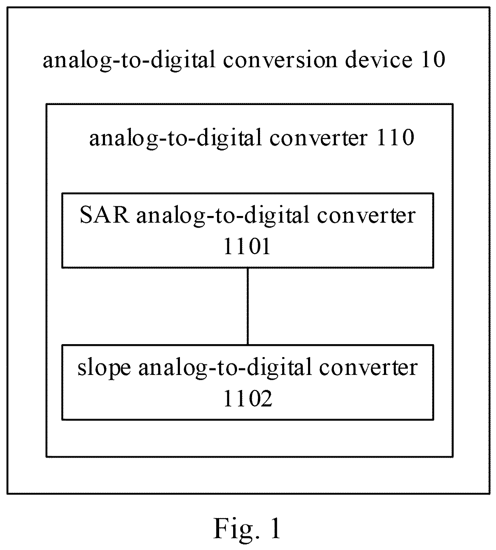

Embodiment of the present invention provides an analog-to-digital conversion device. Fig. 1 is a structural block diagram of an analog-to-digital conversion device according to an embodiment of the present invention. As shown in Fig. 1, the analog-to-digital conversion device 10 includes: an analog-to-digital converter 110, wherein the analog-to-digital converter 110 includes N SAR analog-to-digital converters 1101 and M slope analog-to-digital converters 1102, N is a positive integer greater than or equal to 1, and M is a positive integer greater than 1; output ends of the N SAR analog-to-digital converters 1101 are connected to input ends of M slope analog-to-digital converters 1102.

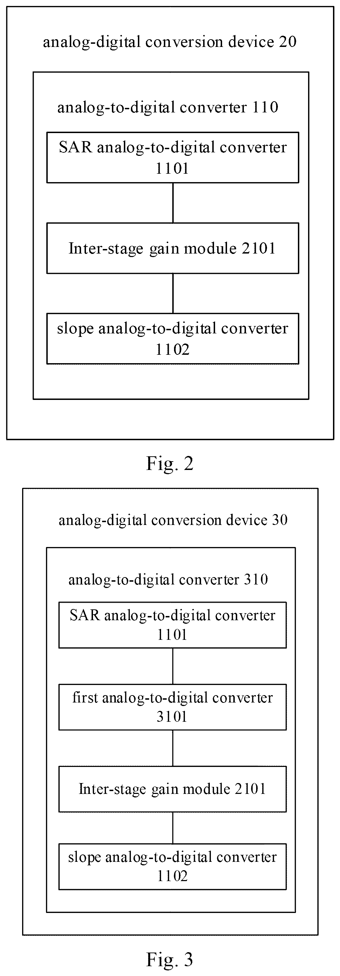

In an embodiment, Fig. 2 is a structural block diagram of an analog-to-digital conversion device according to an embodiment of the present invention. As shown in Fig. 2, the analog-to-digital converter 110 further includes an inter-stage gain module 2101, output ends of N SAR analog-to-digital converters 1101 are connected to input ends of the inter-stage gain module 2101, and output ends of the inter-stage gain module 2101 are connected to input ends of M slope analog-to-digital converters 1102.

In an embodiment, N is equal to 1, M is greater than 1, an output end of one SAR analog-to-digital converter is connected to an input end of an inter-stage gain module, and an output end of the inter-stage gain module is connected to input ends of M slope analog-to-digital converters respectively.

In an embodiment, N is greater than 1, M is greater than 1, and M is k times N, k is an integer greater than 1, wherein each of the N SAR analog-to-digital converters is connected to an input end of an inter-stage gain module, an output end of the inter-stage gain module is connected to an input end of a corresponding k slope analog-to-digital converters in the M slope analog-to-digital converters, forming a first sampling channel, so as to form N first sampling channels in parallel.

In an embodiment, N is greater than 1, M is greater than 1, and N is equal to M. An output end of each SAR analog-to-digital converter among the N SAR analog-to-digital converters is separately connected to an input end of the inter-stage gain module, an output end of the inter-stage gain module is connected to an input end of each of the M slope ADCs, so that each SAR analog-to-digital converter and a corresponding SAR analog-to-digital converter form a second sampling channel, so as to form N parallel second sampling channels.

In an embodiment, N is greater than 1, M is greater than 1, N output ends of the SAR analog-to-digital converters are connected in sequence to input ends of the inter-stage gain module, and output ends of the inter-stage gain module are correspondingly connected in sequence to input ends of M slope analog-to-digital converters, so as to form a third sampling channel.

In the embodiment of the present invention, when the N parallel-connected first sampling channels are working, the N parallel-connected first sampling channels work according to the timing information set by the system or the timing information set by the staff, the specific situation may be that a plurality of first sampling channels work at the same timing, that is, at the same time, and may also be at the same time, there is one first sampling channel working, and similarly, there may also be one or more first sampling channels working at a next moment, or the N first sampling channels are all working states, which need to be set according to actual situations, and are not specifically limited herein. By the same reasoning, the working mode of N parallel-connected second sampling channels in the described embodiment is the same as the working mode of N parallel-connected first sampling channels, and both of them need to work according to the timing information set by the system or the timing information set by the staff in combination with actual situations, which will not be repeated here. By the same reasoning, the number of the third sampling channels may also be more than one, and the working manner is not described in detail above.

In an embodiment, Fig. 3 is a structural block diagram of an analog-to-digital conversion device according to an embodiment of the present invention. As shown in Fig. 3, the analog-to-digital conversion device 30 includes: an analog-to-digital converter 310, wherein the analog-to-digital converter 310 further includes: a plurality of first analog-to-digital converters 3101, and the first analog-to-digital converters 3101 are configured to acquire a quantization residue; a plurality of first analog-to-digital converters 3101, N SAR analog-to-digital converters 1101, an inter-stage gain module 2101 and M slope analog-to-digital converters 1102 are connected in sequence; alternatively, the N SAR analog-to-digital converters 1101, the plurality of first analog-to-digital converters 3101, the inter-stage gain module 2101 and the M slope analog-to-digital converters 1102 are connected in sequence.

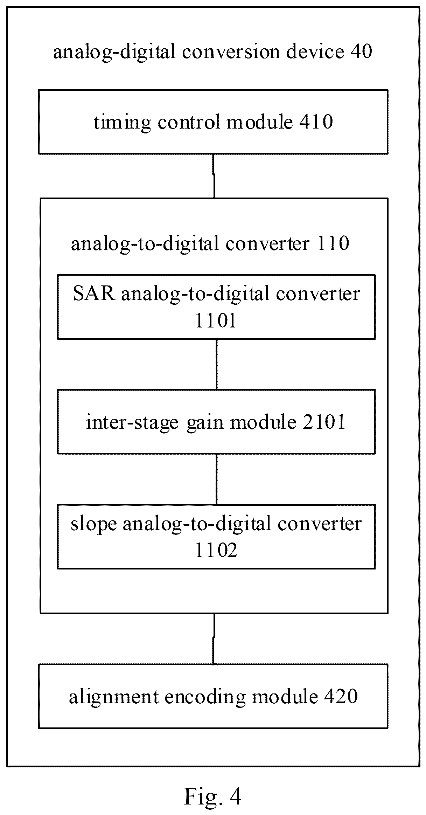

In an embodiment, Fig. 4 is a structural block diagram of an analog-to-digital conversion device according to an embodiment of the present invention. As shown in Fig. 4, the analog-to-digital conversion device 40 further includes: a timing control module 410, configured to provide timing information to the analog-to-digital conversion device 40; the alignment encoding module 420 is configured to perform timing alignment and encode output on the first quantized output signal output by the SAR analog-to-digital converter 1101 and the second quantized output signal output by the slope analog-to-digital converter 1102 according to the timing information.

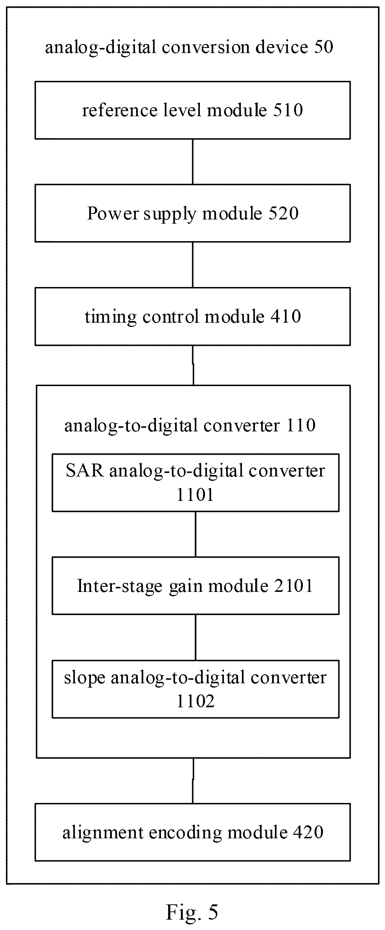

In an embodiment, Fig. 5 is a structural block diagram of an analog-to-digital conversion device according to an embodiment of the present invention. As shown in Fig. 5, the analog-to-digital conversion device 50 further includes: a reference stage module 510, configured to provide a reference stage for the analog-to-digital conversion device 50; the power supply module 520 is configured to supply power to the analog-to-digital conversion device 50.

According to the embodiments of the present invention, providing an analog-to-digital conversion device, including: an analog-to-digital converter, wherein the analog-to-digital converter includes N successive approximation SAR analog-to-digital converters and M slope analog-to-digital converters, N is a positive integer greater than or equal to 1, and M is a positive integer greater than 1; output ends of the N SAR analog-to-digital converters are connected to input ends of the M slope analog-to-digital converters. The problems in the related art that high-speed and high-precision analog-to-digital conversion cannot be achieved and the power consumption of the analog-to-digital conversion are solved, and the effects of high-speed and high-precision analog-to-digital conversion and keeping low power consumption are achieved.

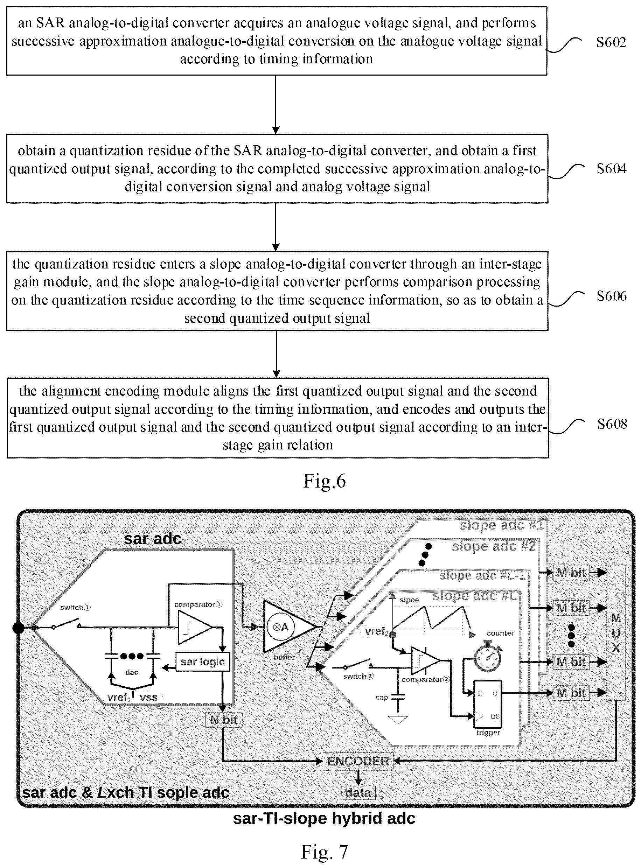

Embodiments of the present invention further provide an analog-to-digital conversion method, which is implemented by the analog-to-digital conversion device in the above embodiments. Fig. 6 is a flowchart of an analog-to-digital conversion method according to an embodiment of the present invention. As shown in Fig. 6, the method includes:
At S602, the SAR analog-to-digital converter acquires an analogue voltage signal, and performs successive approximation register analogue-to-digital conversion on the analogue voltage signal according to timing information;
At S604, according to the completed successive approximation register analog-to-digital conversion signal and the analog voltage signal, obtaining a quantization residue of the SAR analog-to-digital converter, and obtaining a first quantized output signal;
At S606, the quantization residue enters a slope analog-to-digital converter via an inter-stage gain module, and the slope analog-to-digital converter performs comparison processing on the quantization residue according to timing information, so as to obtain a second quantized output signal;
At S608, the alignment encoding module aligns the first quantized output signal and the second quantized output signal according to the timing information, and encodes and outputs the first quantized output signal and the second quantized output signal according to an inter-stage gain relation.

In an embodiment, the step of a slope analog-to-digital converter performing comparison processing on the quantization residues according to the timing information to obtain a second quantized output signal includes: the slope analog-to-digital converter performing comparison processing on the quantization residues and a preset slope signal according to the timing information to obtain the second quantized output signal.

In order to enable those skilled in the art to better understand the technical solutions of the embodiments of the present invention, descriptions will be given below with reference to specific scenario embodiments.

### Scene Embodiment 1

In embodiments of the present invention, advantages of the SAR ADC, the Slope ADC and the Pipeline ADC are extracted, and a new type of analog-to-digital converter architecture is formed. Cascading a SAR ADC and a Slope ADC, wherein a previous stage is the SAR ADC, so that the advantages of high speed and low power consumption thereof are achieved, and a quantization residue can be obtained by means of successive approximation; a subsequent stage is the Slope ADC, so that the advantage of a simple structure is achieved; and an optional inter-stage amplification module is provided between two stages, so as to set a specific inter-stage gain to scale the previous stage residual.

In practical implementation, there are the following combination embodiments:
1. The latter stage may use several (L groups) Slope ADCs for time interleaving, corresponding to the former stage single SAR ADC.
2. The cascading structure constituted by the SAR ADC and the Slope ADC, as a channel, can be extended to time interleaving of several channels (K groups).
3. Several groups (C groups) of SAR ADCs may also form a type of pre-stage, form a cascade with several groups (L groups) of Slope ADCs, and perform time interleaving work.

Wherein, L, K, and C are positive integers.

In the embodiment of the present invention, the time interleaving operation means that the analog-to-digital converter operates according to the timing information set by the system or set by the staffer, specifically, different analog-to-digital converters may work at the same time, that is, at the same time, according to actual requirements, only one analog-to-digital converter works at a same time, and another analog-to-digital converter works at a next time. By the same reasoning, a plurality of analog-to-digital converters may also work simultaneously at a next moment.

According to usage requirements, the above structure can be flexibly selected, and in a form of high energy efficiency, (~100 MS/s)/high(~1 GS/s)/ultrahigh speed (> 10 GS/s), medium (8~10 bit)/high-precision (10∼14 bit) analog-to-digital converters can be realized, thereby overcoming the difficulties in precision, speed and complexity.

In the specific implementation process, the embodiments of the present invention provide the following specific implementation solutions. However, it should be noted that the following specific implementation solutions are only illustrated as examples, and the specific number relationship is not limited.
(1) A former-stage single SAR ADC, and a latter-stage uses several (L groups) Slope ADCs to perform time interleaving operations, so that the former-stage and the latter-stage form a cascade.
(2) Cascading a single SAR ADC and a single Slope ADC, wherein a former-stage is the SAR ADC, a latter-stage is the Slope ADC, and an inter-stage amplification module is optional and is used as a channel to extend to several channels (K groups) to perform time interleaving operation.
(3) The former-stage consists of several groups (C groups) of SAR ADCs, the latter-stage consists of several groups (L groups) of Slope ADCs, the former and latter stages form a cascade, and the time interleaving operation is performed.
(4) On the basis of (1), taking same as a channel, extending to several channels (K groups) to perform time interleaving.

Possible alternative scalable solutions for embodiments of the disclosed scenario are:
(5) Two-stage structure of SAR-Slope ADC is expanded into Sar(several-stage SAR ADC)-Slope(1-stage Slope ADC), x(several-stage other residual-obtainable ADC)-SAR(several-stage SAR ADC)-Slope(1-stage Slope ADC), SAR(several-stage SAR ADC)-x(several-stage other residual-obtainable ADC)-Slope(1-stage Slope ADC).
(6) The above cascade structure of all single channel forms can be extended to several channel time interleaving working forms.

In an embodiment of the present invention, a pre-stage SAR ADC, an optional inter-stage gain module (buffer), a post-stage Slope ADC, an encoder, and common auxiliary peripherals (a clock, a reference level, a power supply, and the like) of the ADC are included in the analog-to-digital conversion apparatus, wherein the pre-stage and post-stage reference levels may be associated or not associated, the pre-stage and post-stage may share a set of clocks or not share the same clock, and the power supply may also be shared or not shared.

The technical principle of the embodiment of the present invention is as follows:
A first phase: after sampling an analog voltage signal, a former-stage N-bit SAR ADC maintains the signal, and performs successive approximation register analogue-to-digital conversion of N-bit precision under the control of a clock_SAR, and after the conversion is completed, a digital-to-analogue converter in the SAR ADC is used to subtract an original sampling signal to obtain a quantization residue of the SAR ADC, so as to obtain a quantization output (N-bit valid digital code) of the SAR ADC;
In a second phase: after obtaining a residual error, the SAR ADC samples (via an optional inter-stage gain module) the residual error onto a post-stage M-bit slope ADC, maintains the signal, and performs comparison and judgement with a designated slope signal under the control of a clock (clock_slope), so as to obtain a quantization output (M-bit valid digital code) of the slope ADC, and this process and the first phase can be serial or parallel;
A third phase: aligning and outputting a pre-stage N-bit valid digital code and a post-stage M-bit valid digital code according to the relationship of gains between stages;
A fourth phase: in a case that time interleaving work is involved, aligning a former stage N-bit valid digital code and a next stage M-bit valid digital code according to a timing relationship, and encoding and outputting according to an inter-stage gain relationship, and in a case that time interleaving is not performed, not performing this phase.

### Scene Embodiment 2

This embodiment corresponds to the specific solution (1) in the first scenario embodiment. Fig. 7 is a schematic structural diagram of an analog-to-digital conversion device according to an embodiment of a scenario of the present invention. As shown in Fig. 7, recommendation configuration is as follows: quantization precision N≈M of a former-stage sar and a latter-stage slope; it is suitable for high-speed and high-precision application scenarios (8-14bit, ~1GS/s).

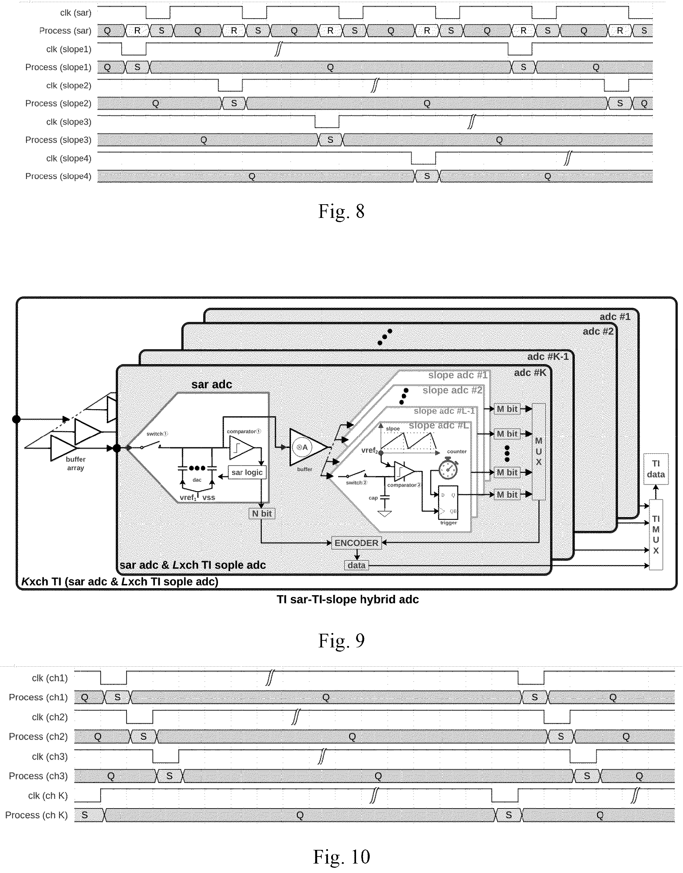

For example , L=4, as shown in Fig. 8, in a clk(sar) signal, a low level indicates a sar ADC sampling stage, and a high level indicates a sar ADC quantization and residual sampling to a slope ADC stage; in the Process (sar) signal, Q represents a quantization phase of the sar ADC, R represents a residual maintenance phase of the sar ADC and a sampling phase of the slope ADC, and S represents a sampling phase of the sar ADC; in a Process (slope1) signal, Q represents a quantization phase of a first slope1 ADC, and also a high level phase of a clk (slope1) signal; S represents a sampling phase of the first slope1 ADC, and also a low level phase of the clk (slope1) signal; by analogy, the process (slope L) signal and the clk (slope L) respectively correspond to the Lth slope ADC, S represents a sampling phase, and Q represents a quantization phase. Time coordination requires that the rate of a single sar ADC is not less than L times the rate of a single slope ADC.

### Scene Embodiment 3

This embodiment corresponds to the specific solution (4) in the first scenario embodiment. Fig. 9 is a structural schematic diagram of an analog-to-digital conversion device according to an embodiment of a scenario of the present invention. As shown in Fig. 9, a recommended configuration is as follows: quantization accuracy N of a former-stage sar and a latter-stage slope is greater than M; it is suitable for an ultra-high-speed medium-high-precision usage scenario (8-14bit, xxGS/s).

Taking K channels as an example, as shown in Fig. 10, in a clk(ch1) signal, a low level represents a sampling phase of a first channel, and a high level represents a quantization phase of the first channel; in the Process (ch1) signal, Q represents a first channel quantization phase, and S represents a first channel sampling phase; by analogy, a signal of Process(ch K) and a signal of clk(ch K) respectively correspond to the Kth channel, S represents a sampling phase, and Q represents a quantization phase. With reference to the first scheme, the time coordination requires that the sampling time of a single channel is not higher than the conversion time of each channel.

### Scene Embodiment 4

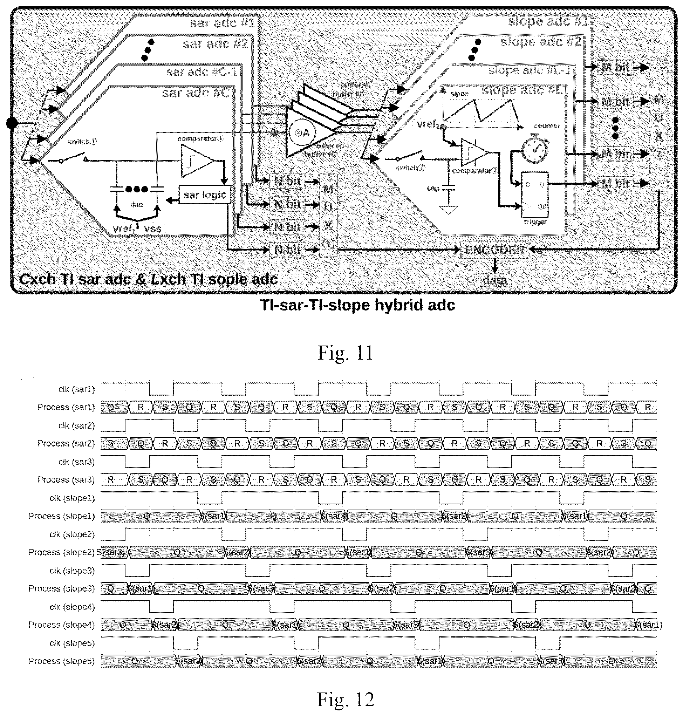

This embodiment corresponds to the specific solution (3) in the first scenario embodiment. Fig. 11 is a structural principle diagram of an analog-to-digital conversion device according to a scenario embodiment of the present invention. As shown in Fig. 11, the recommendation configuration is as follows: quantization accuracy N of a former-stage sar and a latter-stage slope is greater than M, and a channel number C is less than L; it is suitable for high-speed and high-precision usage scenarios (8-14bit, 1xGS/s).

For example , C=3 and L=5 , that is, three sar ADCs are interleaved in a former stage, and five slope ADCs are interleaved in a latter stage; as shown in figure 12, in a clk (sar1) signal, a low level represents a sar ADC sampling stage, and a high level represents a sar ADC quantization and residual sampling to a slope ADC stage; in the Process (sar1) signal, Q represents a quantization phase of the sar ADC, R represents a residual maintenance phase of the sar ADC and a sampling phase of the slope ADC, and S represents a sampling phase of the sar ADC; in the Process (slope1) signal, Q represents a quantization phase of the first slope1 ADC, and also a high level phase of the clk (slope1) signal; S(sar1) represents a sampling phase of the first slope1 ADC, is a residual of the sampled first sar ADC, and also a low level phase of the clk (slope1) signal; by analogy, clk(sar C) and processes(sar C) represent a sar ADC of the cth channel, a process(slope L) signal and clk(slope L) respectively correspond to an Lth slope ADC, S(sar C) represents a sampling phase and samples a residual of the cth sar ADC, and Q represents a quantization phase. Time coordination requires L times the rate of a single sar ADC to be equal to C times the rate of a single slope ADC.

In the above scenario embodiments of the embodiments of the present invention, the recommended configuration does not represent a unique configuration, and different configurations under the same or similar architecture are all within the technical scope of the embodiments of the present invention, and other alternative or extendable types described in specific solutions (4) and (5) of the first scenario embodiment are all within the technical scope of the embodiments of the present invention.

In analog-to-digital conversion techniques, a layout may be divided into two blocks for an analog-to-digital converter product, wherein a regular capacitor (metal layer) with a large area symmetry is present nearby which is accompanied by a symmetrical compact transistor device circuit (areas such as polysilicon and metal lines), another large-area capacitor (metal layer) also appears nearby, with the solution of a transistor device circuit (areas such as polysilicon and metal lines) occupying a small area proportion, it shall fall within the scope of protection of the embodiments of the present invention.

In conclusion, the analog-to-digital conversion device provided in the embodiment of the present invention has the following effects: the advantages of a sar ADC, a slice ADC, and a pipeline ADC are integrated; one ADC is divided into several segments; one segment is processed in the sar ADC, and the other segment is processed in the slice ADC; parallel or serial quantization is performed; and finally, quantization results of two types of ADCs are encoded and combined and output, so as to obtain a complete ADC output result. The former stage uses a sar ADC, which uses high energy efficiency ratio and high speed characteristics thereof, because the sar ADC is particularly suitable for performing rapid conversion with medium precision, and a quantization residue can be easily obtained after the conversion is completed. The idea of adopting a pipeline ADC is that a pre-stage residual is sampled to a post-stage slope ADC by means of an optional inter-stage gain. The idle time after the sar ADC conversion can be used, and the post-stage serial or parallel operation can improve the utilization rate of time (typically improving the rate by a factor of 2). The latter stage adopts a slope ADC, which has a simple structure and is suitable for time interleaving work formed by multi-channel expansion. The embodiments of the present invention are not simple superposition of a sar ADC, a slope ADC, and a pipeline ADC, but form a new type of analog-to-digital converter architecture with a structure and a precise timing, so as to implement high-speed and high-precision analog-to-digital conversion features.

The analog-to-digital converter technology provided in the embodiments of the present invention can convert an analog signal into a digital signal. Possible applications include, but are not limited to, signal base stations, mobile phone communications, wifi, bluetooth, optical communications, precision measuring instruments, sensor systems, automobiles, radars, and hydrophonics. By time interleaving of several channels, the technical solution of the embodiments of the present invention may implement a high-speed/ultra-high-speed analog-to-digital converter, and may also implement a high-speed/low-speed high-precision analog-to-digital converter, that is, may be compatible in a low-precision direction and a low-speed direction. It can also be used to solve the problem that the matching performance and noise of the sar ADC and the swing ADC affect the accuracy, and is compatible to implement an ultra-high-precision analog-to-digital converter.

The above are only preferred embodiments of the embodiments of the present invention, and are not intended to limit the embodiments of the present invention. For those skilled in the art, the embodiments of the present invention may have various modifications and variations. Any modifications, equivalent replacements, improvements and the like made within the principle of the embodiments of the present invention shall fall within the scope of protection of the embodiments of the present invention.

## Claims

1. An analog-to-digital conversion device, comprising: an analog-to-digital converter, the analog-to-digital converter comprising N successive approximation register ,SAR, analog-to-digital converters and M slope analog-to-digital converters, wherein N is a positive integer greater than or equal to 1, and M is a positive integer greater than 1;
and output ends of the N SAR analog-to-digital converters are connected to input ends of the M slope analog-to-digital converters.

2. The device according to claim 1, wherein the analog-to-digital converter further comprises: an inter-stage gain module, wherein output ends of the N SAR analog-to-digital converters are connected to input ends of the inter-stage gain module, and an output end of the inter-stage gain module is connected to input ends of the M slope analog-to-digital converters.

3. The device according to claim 1, wherein N is equal to 1, M is greater than 1, an output end of one of the SAR analog-to-digital converters is connected to an input end of an inter-stage gain module, and output ends of the inter-stage gain module is connected to input ends of M slope analog-to-digital converters respectively.

4. The device of claim 1, wherein N is greater than 1, M is greater than 1, and M is a k-multiple of N, k is an integer greater than 1, in which each SAR analog-to-digital converter in the N SAR analog-to-digital converters is connected to an input end of an inter-stage gain module, output ends of the inter-stage gain module are connected to an input end of a corresponding k slope analog-to-digital converters in the M slope analog-to-digital converters, forming a first sampling channel, so as to form N first sampling channels in parallel.

5. The device according to claim 1, wherein N is greater than 1, M is greater than 1, and N is equal to M, and an output end of each SAR analog-to-digital converter among the N SAR analog-to-digital converters is separately connected to an input end of the inter-stage gain module, an output end of the inter-stage gain module is connected to an input end of each of the M slope ADCs, so that each SAR analog-to-digital converter and a corresponding SAR analog-to-digital converter form a second sampling channel, so as to form N parallel second sampling channels.

6. The device according to claim 1, wherein N is greater than 1, M is greater than 1, the output ends of N SAR analog-to-digital converters are connected in sequence to the input ends of the inter-stage gain module, and the output ends of the inter-stage gain module are correspondingly connected in sequence to the input ends of M slope analog-to-digital converters, so as to form a third sampling channel.

7. The device according to claim 2, further comprising: a plurality of first analog-to-digital converters, wherein the first analog-to-digital converters are configured to acquire quantization residues;
output ends of the plurality of first analog-to-digital converters are connected to input ends of the N SAR analog-to-digital converters, input ends of the N SAR analog-to-digital converters are connected to input ends of the inter-stage gain module, and output ends of the inter-stage gain module are connected to input ends of the M slope analog-to-digital converters;
or, input ends of the N SAR analog-to-digital converters are connected to input ends of a plurality of first analog-to-digital converters, output ends of the plurality of first analog-to-digital converters are connected to input ends of the inter-stage gain module, and output ends of the inter-stage gain module are connected to input ends of the M slope analog-to-digital converters.

8. The device according to claim 1, further comprising:
a timing control module, configured to provide timing information to the analog-to-digital conversion device;
an alignment encoding module, configured to perform timing alignment and encoding output on the first quantized output signal output by the SAR analog-to-digital converter and the second quantized output signal output by the slope analog-to-digital converter according to the timing information.

9. The device according to claim 1, further comprising:
a reference stage module, configured to provide a reference stage to the analog-to-digital conversion device;
a power supply module, configured to supply power to the analog-to-digital conversion device.

10. An analog-to-digital conversion method, wherein the method implemented by the analog-to-digital conversion device according to any one of claims 1 to 9, comprising:
the SAR analog-to-digital converter acquires an analogue voltage signal, and performs successive approximation analogue-to-digital conversion on the analogue voltage signal according to timing information;
obtaining a quantization residue of the SAR analog-to-digital converter, and obtaining a first quantized output signal, according to the successive approximation analog-to-digital conversion signal and the analog voltage signal;
the quantization residue enters the slope analog-to-digital converter via the inter-stage gain module, and the slope analog-to-digital converter performs comparison processing on the quantization residue according to the timing information, so as to obtain a second quantized output signal;
the alignment encoding module aligns the first quantized output signal and the second quantized output signal according to the timing information, and encodes output the first quantized output signal and the second quantized output signal according to an inter-stage gain relation.
